# EUROPEAN PATENT APPLICATION

(11) **EP 4 686 534 A1**
(43) Date of publication of application: **04.02.2026**
(21) Application number: 25191531.0
(22) Date of filing: 24.07.2025
(51) Int. Cl.: B25J 9/16

(54) **CONTROLLER**

(30) Priority: 30.07.2024 JP 2024123320
(71) Applicant: Seiko Epson Corporation, Tokyo 160-8801 (JP)
(72) Inventor: OKUBO, Yuta, Suwa-shi, Nagano 392-8502 (JP); IIJIMA, Takayuki, Suwa-shi, Nagano 392-8502 (JP)
(74) Representative: MERH-IP Matias Erny Reichl Hoffmann Patentanwälte PartG mbB

(57) **Abstract**

A controller includes a power supply circuit board to which a first voltage is input, and a control circuit board and a system circuit board to which a second voltage smaller than the first voltage is input, the power supply circuit board and the system circuit board are disposed along the bottom panel and arranged side by side in a first direction such that the power supply circuit board is located on a rear panel side and the system circuit board is located on a front panel side, the control circuit board is disposed to overlap with the system circuit board in plan view of the bottom panel, the system circuit board has a first connector connected to a robot, and the control circuit board has a second connector connected to an external device that generates a drive command program for the robot.

## Description

The present application is based on, and claims priority from JP Application Serial Number 2024-123320, filed July 30, 2024, the disclosure of which is hereby incorporated by reference herein in its entirety.

### BACKGROUND

### 1. Technical Field

The present disclosure relates to a controller.

### 2. Related Art

In JP-A-2013-13967, a robot controller that controls driving of a robot is disclosed. The robot controller includes a drive voltage generation board and a control board disposed to overlap with the drive voltage generation board. In addition, a plurality of function expansion ports connected to the robot, peripheral devices, and the like is arranged in a line in a horizontal direction on the control board, and each of the ports is exposed to the outside from a front panel of the robot controller.

Recent robot controllers are required to be reduced in size and improved in function expandability.

However, in the robot controller of JP-A-2013-13967, since the plurality of function expansion ports is arranged in a line in the horizontal direction, when the number of ports is increased to further improve the function expandability, the robot controller becomes wider, and the installation area of the robot controller increases. On the other hand, when the plurality of ports is arranged at a narrow pitch in order to prevent an increase in the installation area of the robot controller, it becomes difficult to perform the operation of inserting and removing a cable into and from each port, and the operability deteriorates. In addition, in the robot controller of JP-A-2013-13967, the drive voltage generation board to which an alternating current (AC) voltage of 200 V is input from an external power supply and the control board to which a direct current (DC) voltage of 24 V generated by the drive voltage generation board is input overlap with each other, and there is a problem in which crosstalk therebetween is likely to occur.

### SUMMARY

A controller of the present disclosure is a controller that controls driving of a robot on which a motor is mounted, the controller including a housing including a bottom panel, a front panel located on a first side in a first direction along the bottom panel and standing with respect to the bottom panel, and a rear panel located on a second side in the first direction and standing with respect to the bottom panel, a power supply circuit board that is disposed in the housing and to which a first voltage is input, and a control circuit board and a system circuit board that are disposed in the housing and to which a second voltage smaller than the first voltage is input, in which the power supply circuit board and the system circuit board are disposed along the bottom panel and are arranged side by side in the first direction such that the power supply circuit board is located on the second side in the first direction and the system circuit board is located on the first side in the first direction, the control circuit board is disposed to overlap with the system circuit board in plan view of the bottom panel, the system circuit board has a first connector connected to the robot, and the control circuit board has a second connector exposed from the front panel to an outside of the housing and connected to an external device that generates a drive command program for the robot.

### BRIEF DESCRIPTION OF THE DRAWINGS

FIG. 1 is an overall view illustrating a robot system according to a preferred embodiment.
FIG. 2 is a perspective view illustrating an inside of a controller.
FIG. 3 is a plan view illustrating the inside of the controller with a control circuit board, an interface (IF) board, and a safety board omitted.
FIG. 4 is a plan view illustrating the inside of the controller with the safety board omitted.
FIG. 5 is a sectional view illustrating a floating connector for electrically connecting a system circuit board and the control circuit board.
FIG. 6 is a plan view illustrating the inside of the controller.
FIG. 7 is a plan view illustrating a front panel.

### DESCRIPTION OF EMBODIMENTS

Hereinafter, a controller of the present disclosure will be described in detail based on an embodiment illustrated in the accompanying drawings.

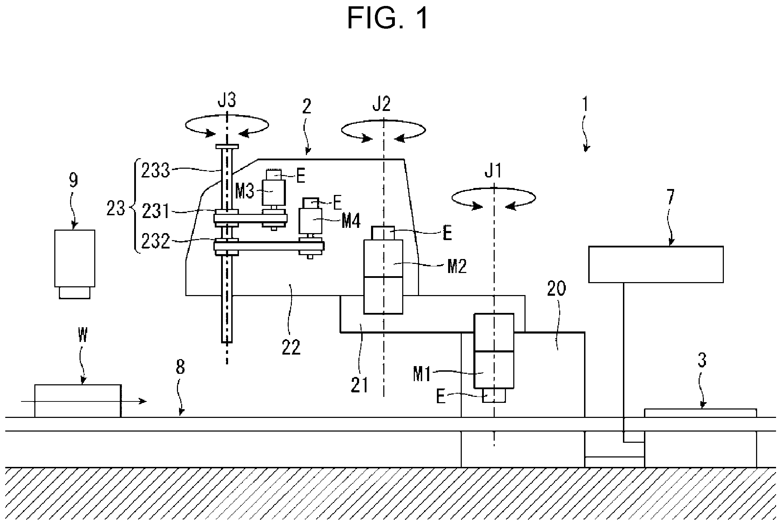

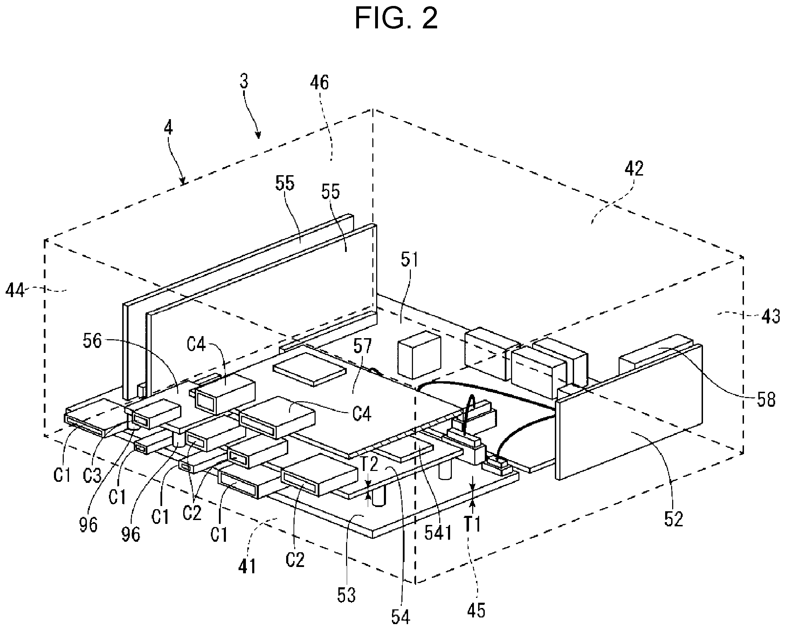

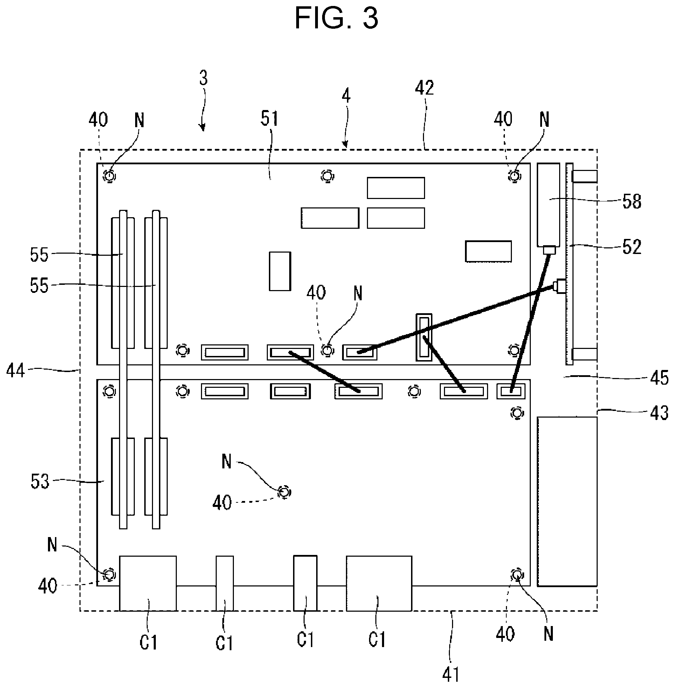

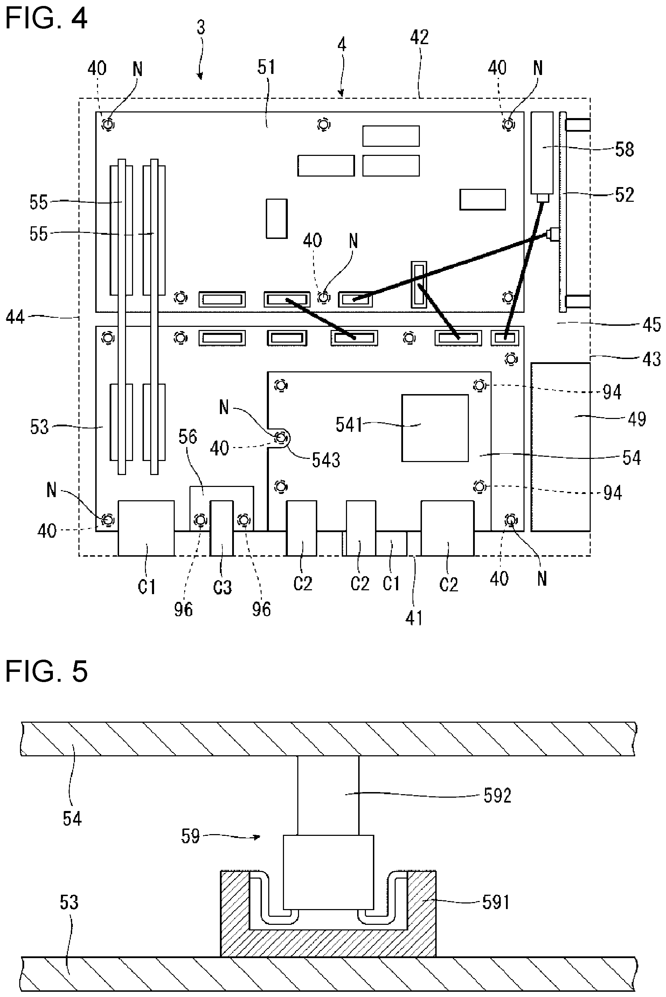

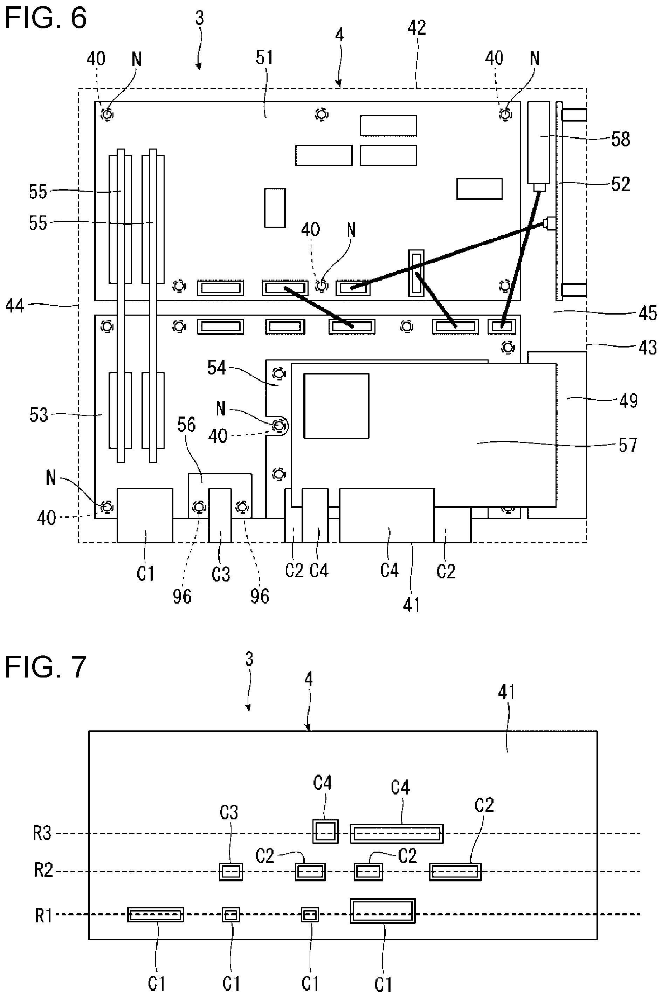

FIG. 1 is an overall view illustrating a robot system according to a preferred embodiment. FIG. 2 is a perspective view illustrating an inside of a controller. FIG. 3 is a plan view illustrating the inside of the controller with a control circuit board, an IF board, and a safety board omitted. FIG. 4 is a plan view illustrating the inside of the controller with the safety board omitted. FIG. 5 is a sectional view illustrating a floating connector for electrically connecting a system circuit board and the control circuit board. FIG. 6 is a plan view illustrating the inside of the controller. FIG. 7 is a plan view illustrating a front panel.

A robot system 1 illustrated in FIG. 1 includes a robot 2, a conveyor 8 and a camera 9 which are peripheral devices that cooperate with the robot 2, a controller 3 for controlling driving of the robot 2, and a host computer 7 which is an external device that generates an operation command program for the robot 2 and inputs the operation command program to the controller 3. In the robot system 1 described above, the conveyor 8 transports a workpiece W in a predetermined direction at a predetermined speed, the camera 9 captures an image of the workpiece W on the conveyor 8, and the robot 2 performs a predetermined operation on the workpiece W on the conveyor 8 downstream of the camera 9 according the operation command program. However, the configuration of the robot system 1 is not particularly limited, and for example, peripheral devices such as the conveyor 8 and the camera 9 may be omitted, or peripheral devices other than the conveyor 8 and the camera 9 may be provided. In addition, the host computer 7 may be removed from the controller 3 after the operation command program is input to the controller 3.

The conveyor 8 is a belt conveyor and transports the workpiece W in the arrow direction at a predetermined speed. The camera 9 is located upstream of the robot 2 and captures an image of the workpiece W on the conveyor 8 from above the conveyor 8. The position in the image acquired by the camera 9 is known, and the position of the workpiece W at the imaging time can be obtained from the position of the workpiece W in the image. By combining the position with the transport direction and the transport speed of the workpiece W by the conveyor 8, the movement trajectory of the workpiece W from the imaging time can be predicted.

As illustrated in FIG. 1, the robot 2 is a selective compliance assembly robot arm (SCARA) robot (horizontal articulated robot) and includes a base 20 fixed to a floor, a first arm 21 connected to the base 20 and rotating around a first rotation axis J1 extending in the vertical direction with respect to the base 20, a second arm 22 connected to the first arm 21 and rotating around a second rotation axis J2 extending in the vertical direction with respect to the first arm 21, and a working head 23 disposed at a leading end portion of the second arm 22.

In addition, the working head 23 includes a spline nut 231 and a ball screw nut 232 which are coaxially arranged at the leading end portion of the second arm 22, and a spline shaft 233 inserted through the spline nut 231 and the ball screw nut 232. Although not illustrated, an end effector corresponding to the purpose of work is attached to a lower end portion of the spline shaft 233.

In the working head 23 described above, the rotation of the spline nut 231 causes the spline shaft 233 to rotate around a third rotation axis J3 extending in the vertical direction and move linearly (move up and down) along the third rotation axis J3, the rotation of the ball screw nut 232 causes the spline shaft 233 to move linearly along the third rotation axis J3, and the rotation of both the spline nut 231 and the ball screw nut 232 causes the spline shaft 233 to rotate around the third rotation axis J3.

In addition, the robot 2 includes a motor M1 that rotates the first arm 21 around the first rotation axis J1 with respect to the base 20, a motor M2 that rotates the second arm 22 around the second rotation axis J2 with respect to the first arm 21, a motor M3 that rotates the spline nut 231, and a motor M4 that rotates the ball screw nut 232. Each of the motors M1, M2, M3, and M4 is an AC motor, in particular a three phase AC motor. In addition, each of the motors M1, M2, M3, and M4 includes an encoder E for detecting the rotation amount of a rotation axis.

Although the robot 2 has been described above, the configuration of the robot 2 is not particularly limited. For example, the robot 2 may be a six-axis articulated robot.

For example, the controller 3 controls driving of the robot 2 by independently driving each of the motors M1, M2, M3, and M4 based on a drive command program input from the host computer 7 and causes the robot 2 to execute a predetermined operation.

As illustrated in FIG. 2, the controller 3 has a housing 4. The housing 4 has a rectangular parallelepiped shape and includes a rectangular frame-shaped side wall panel including a front panel 41, a rear panel 42, a first side panel 43, and a second side panel 44, a bottom panel 45 that closes a lower end opening of the side wall panel, and a top panel 46 that closes an upper end opening of the side wall panel. Therefore, the panels 41 to 44 included in the side wall panel are disposed in a state of standing with respect to the bottom panel 45. Among these six panels 41 to 46, at least the top panel 46 is detachably fixed to other panels by screws or the like. Therefore, by removing the top panel 46, access to the inside of the housing 4 is facilitated, and assembly, maintenance, and the like of the controller 3 can be easily performed. However, the configuration of the housing 4 is not particularly limited and is not limited to a structure in which the front panel 41, the rear panel 42, the side wall panel, the bottom panel 45, and the top panel 46 are fixed by screws, and a plurality of panels may be integrally formed.

Hereinafter, for convenience of description, a direction in which the bottom panel 45 and the top panel 46 are arranged is referred to as a "height direction", a direction in which the front panel 41 and the rear panel 42 are arranged is referred to as a "depth direction" which is a first direction, and a direction in which the first and second side panels 43 and 44 are arranged is referred to as a "width direction" which is a second direction orthogonal to the first direction.

In addition, as illustrated in in FIG. 2, the controller 3 includes a power supply circuit board 51, a sub-power supply circuit board 52, a system circuit board 53, a control circuit board 54, a motor drive board 55, an IF board 56, a safety board 57, and a fan 58, which are accommodated in the housing 4.

For example, the power supply circuit board 51 is connected to an external power supply and converts an AC voltage of 200 V supplied from the external power supply into a DC voltage used in the controller 3. In addition, the control circuit board 54 executes an operation command program for the robot 2 input from the host computer 7 such as a teaching pendant and generates a position command indicating a movement destination of the robot 2 according to a target position of the robot 2 set by the operation command program. In addition, the system circuit board 53 calculates a rotation amount of each of the motors M1 to M4 necessary for moving the robot 2 to a position indicated by the position command generated by the control circuit board 54 and generates a voltage command corresponding to the calculated rotation amount. In addition, the motor drive board 55 converts the DC voltage input from the power supply circuit board 51 into a multi-phase AC voltage of each of the motors M1 to M4 based on a control signal corresponding to the voltage command input from the system circuit board 53 and inputs the multi-phase AC voltage to each of the motors M1 to M4. In addition, the IF board 56 acquires the driving state of the conveyor 8. In addition, the safety board 57 monitors an output signal of each encoder E included in the robot 2 and detects an abnormality of the robot 2. The functions of the boards 51 to 57 have been briefly described above. Hereinafter, each of the boards 51 to 57 will be sequentially described in detail.

### Power Supply Circuit Board 51

As illustrated in FIGS. 2 and 3, the power supply circuit board 51 is fixed to the bottom panel 45. Specifically, the power supply circuit board 51 is mounted on columnar legs 40 erected upward from an inner surface of the bottom panel 45 and is fixed to each of the legs 40 by a screw N. In addition, the power supply circuit board 51 has a substantially rectangular shape in plan view. In addition, the power supply circuit board 51 is disposed along the bottom panel 45. In particular, in the present embodiment, the power supply circuit board 51 is parallel to the bottom panel 45. In addition, the power supply circuit board 51 is disposed closer to the rear panel 42. The term "parallel" includes not only a case where the power supply circuit board 51 is parallel to the bottom panel 45, but also a case where the power supply circuit board 51 is inclined with respect to the bottom panel 45 within a range of, for example, approximately ±5° or less, which can be regarded as being parallel to the bottom panel 45 in terms of technical common sense, in consideration of the accuracy of component formation and assembly, and the like. The meaning of "parallel" is the same hereinafter.

The power supply circuit board 51 described above removes noise from the AC voltage of 200 V supplied from the external power supply using a noise filter (not illustrated). In addition, for example, the power supply circuit board 51 converts the AC voltage of 200 V, from which noise is removed, into a first voltage V1, which is a DC voltage of 280 V, using a rectifier circuit such as a diode bridge and inputs the first voltage V1 to each motor drive board 55. Further, the power supply circuit board 51 inputs the first voltage V1 to the sub-power supply circuit board 52.

Although the power supply circuit board 51 has been described above, the configuration of the power supply circuit board 51 is not particularly limited.

### Sub-power Supply Circuit Board 52

As illustrated in FIGS. 2 and 3, the sub-power supply circuit board 52 is fixed to the first side panel 43. The sub-power supply circuit board 52 is disposed along the first side panel 43. In particular, in the present embodiment, the sub-power supply circuit board 52 is parallel to the first side panel 43. In this manner, by disposing the sub-power supply circuit board 52 in a state of standing with respect to the power supply circuit board 51, it is possible to suppress planar spreading of the controller 3 and to suppress the installation area of the controller 3 to be small. Therefore, the controller 3 can be easily installed.

In addition, the sub-power supply circuit board 52 is electrically connected to the power supply circuit board 51 through a cable. The AC voltage of 200 V, from which noise is removed by the noise filter, input from the power supply circuit board 51 through the cable is converted into a DC voltage of 24 V, and the DC voltage is input to the power supply circuit board 51 through the cable. The power supply circuit board 51 inputs the DC voltage of 24 V input from the sub-power supply circuit board 52 to the system circuit board 53.

Although the sub-power supply circuit board 52 has been described above, the configuration of the sub-power supply circuit board 52 is not particularly limited. Further, the sub-power supply circuit board 52 may be omitted, and the power supply circuit board 51 may have the function of the sub-power supply circuit board 52.

### System Circuit Board 53

The system circuit board 53 is electrically connected to the power supply circuit board 51 through a cable. The DC voltage of 24 V is input to the system circuit board 53 from the power supply circuit board 51. In this manner, the power supply circuit board 51 that handles the DC voltage of 280 V and the system circuit board 53 that handles the DC voltage of 24 V lower than 200 V are configured by separate boards, and thus it is possible to effectively suppress crosstalk therebetween. Therefore, noise is less likely to occur, and the controller 3 can control the robot 2 more accurately.

In addition, as illustrated in FIGS. 2 and 3, the system circuit board 53 is fixed to the bottom panel 45. Specifically, the system circuit board 53 is mounted on the columnar legs 40 erected on the bottom panel 45 and is fixed to each leg 40 by the screw N as a fixing member. In addition, the system circuit board 53 has a substantially rectangular shape in plan view and has substantially the same size as the power supply circuit board 51. In addition, the system circuit board 53 is disposed along the bottom panel 45. In particular, in the present embodiment, the system circuit board 53 is parallel to the bottom panel 45. Further, the system circuit board 53 is disposed closer to the front panel 41. Moreover, the system circuit board 53 is disposed at substantially the same height as the power supply circuit board 51 and is located in front of the power supply circuit board 51 (on the front panel 41 side). That is, the system circuit board 53 and the power supply circuit board 51 are arranged side by side in the depth direction and do not overlap with each other in plan view in the height direction. With such an arrangement, the system circuit board 53 and the power supply circuit board 51 can be disposed so as to be separated from each other as much as possible in the housing 4 and crosstalk therebetween can be more effectively suppressed.

In addition, as illustrated in FIG. 2, a thickness T1 of the system circuit board 53 is greater than a thickness T2 of the control circuit board 54. That is, T1 > T2 is satisfied. As will be described later, the system circuit board 53 is larger than the control circuit board 54 and also has a larger number of connectors for cable connection disposed thereon. Therefore, by making the system circuit board 53 thicker than the control circuit board 54, the strength of the system circuit board 53 can be increased, and damage to the system circuit board 53 due to stress imposed during connector connection can be effectively suppressed. Although not particularly limited, T1= 1.6 mm and T2 = 1.2 mm are used in the present embodiment.

In addition, as illustrated in FIGS. 2 and 3, the system circuit board 53 has a plurality of first connectors C1. The plurality of first connectors C1 is arranged in a line in the width direction along a side of an upper surface of the system circuit board 53 on the front panel 41 side and is exposed to the outside of the controller 3 through holes formed in the front panel 41. That is, the first connectors C1 are fixed to the system circuit board 53, and some portions of the first connectors C1 are inserted into holes formed in the front panel 41 and exposed from the front panel 41 to the outside of the housing 4. Here, the term "exposed" means that the first connectors C1 need only be visually recognized when viewed in a direction of the front panel 41, and the first connectors C1 do not have to protrude from the front panel 41. The plurality of first connectors C1 include, for example, a connector connected to each encoder E to acquire an output signal of each encoder E, a connector connected to an end effector attached to the robot 2 to acquire a signal from the end effector, and a connector connected to the camera 9 to acquire image data captured by the camera 9. However, the number, arrangement, functions, specifications, and the like of the first connectors C1 are not particularly limited.

The system circuit board 53 described above converts the DC voltage of 24 V input from the power supply circuit board 51 into DC voltages of 17 V, 16 V, 5 V, 3.3 V, and the like and inputs the respective DC voltages of 24 V, 17 V, 16 V, 5 V, and 3.3 V (hereinafter, referred to as a second voltage V2) to necessary portions such as the system circuit board 53, the control circuit board 54, the motor drive board 55, the IF board 56, and the safety board 57. In addition, as described above, the system circuit board 53 calculates the rotation amount of each of the motors M1 to M4 necessary for moving the robot 2 to a position indicated by the position command generated by the control circuit board 54 and generates a voltage command of each phase of a U phase, a V phase, and a W phase according to the calculated rotation amount for each of the motors M1 to M4.

Although the system circuit board 53 has been described above, the configuration of the system circuit board 53 is not particularly limited. For example, the thickness of the system circuit board 53 may be equal to or less than the thickness of the control circuit board 54.

### IF Board 56

As illustrated in FIGS. 2 and 4, the IF board 56 is located above the system circuit board 53 and is fixed to the system circuit board 53 with supporting columns 96 interposed therebetween. In addition, the IF board 56 is disposed along the bottom panel 45. In particular, in the present embodiment, the IF board 56 is parallel to the bottom panel 45. The IF board 56 is electrically connected to the system circuit board 53 through a cable (not illustrated).

In addition, as illustrated in FIG. 4, the IF board 56 overlaps with the system circuit board 53 in plan view in the height direction. According to such a configuration, planar spreading of the controller 3 (spreading in the width direction and the depth direction) can be suppressed, and the installation area of the controller 3 can be suppressed to be small. Therefore, the controller 3 can be easily installed.

In addition, as illustrated in FIG. 4, the IF board 56 does not overlap with the power supply circuit board 51 in plan view in the height direction. Therefore, the IF board 56 and the power supply circuit board 51 can be disposed so as to be separated from each other as much as possible in the housing 4, and crosstalk therebetween can be effectively suppressed. As a result, noise is less likely to occur, and the controller 3 can control the robot 2 more accurately.

In addition, as illustrated in FIGS. 2 and 4, the IF board 56 has one third connector C3. The third connector C3 is disposed along a side of an upper surface of the IF board 56 on the front panel 41 side and faces the outside of the controller 3 through a hole formed in the front panel 41. The third connector C3 is connected to the conveyor 8 and acquires operation information of the conveyor 8, in particular, information relating to a transport speed of the workpiece W. However, the number, arrangement, functions, specifications, and the like of the third connector C3 are not particularly limited.

Although the IF board 56 has been described above, the configuration of the IF board 56 is not particularly limited. In addition, the IF board 56 may be omitted.

### Control Circuit Board 54

As illustrated in FIGS. 2 and 4, the control circuit board 54 is located above the system circuit board 53 and is fixed to the system circuit board 53 with supporting columns 94 interposed therebetween. In addition, the control circuit board 54 has a substantially rectangular shape in plan view and has a smaller area than the system circuit board 53. In addition, the control circuit board 54 is disposed along the bottom panel 45. In particular, in the present embodiment, the control circuit board 54 is parallel to the bottom panel 45. In this manner, by disposing the control circuit board 54 having a relatively small area above the system circuit board 53 having a larger area than the control circuit board 54, that is, by disposing the system circuit board 53 between the bottom panel 45 and the control circuit board 54, the control circuit board 54 is not hidden under the system circuit board 53 and is easily visible. Some of the first connectors C1 overlap with the control circuit board 54 in plan view in the height direction. Therefore, the control circuit board 54 is located at a height at which the control circuit board 54 does not come into contact with the first connectors C1.

In addition, as illustrated in FIG. 5, the control circuit board 54 is electrically connected to the system circuit board 53 with a floating connector 59 interposed therebetween. In addition, the floating connector 59 is disposed to overlap with the control circuit board 54 in plan view in the height direction and includes a movable side connector 591 disposed on the upper surface of the system circuit board 53 and a fixed side connector 592 disposed on a lower surface of the control circuit board 54 and fitted into a floating portion of the movable side connector 591. According to such a configuration, it is possible to absorb a mounting error between the system circuit board 53 and the control circuit board 54 which occurs at the time of mounting, and a load is unlikely to be imposed on the system circuit board 53 and the control circuit board 54. In addition, for example, as compared with a case where the system circuit board 53 and the control circuit board 54 are connected to each other through a cable, the connection work therebetween is facilitated. Moreover, it is also possible to effectively suppress deterioration in electrical characteristics due to the cable coming into contact with another member or vibrating. Further, since no cable is used, the controller 3 can be reduced in size.

However, a method of electrically connecting the system circuit board 53 and the control circuit board 54 is not particularly limited. For example, the movable side connector 591 may be disposed on the control circuit board 54 and the fixed side connector 592 may be disposed on the system circuit board 53. Alternatively, a connector other than the floating connector 59 may be used, or the connection may be made through a cable.

In addition, as illustrated in FIG. 4, the control circuit board 54 overlaps with the system circuit board 53 in plan view in the height direction. According to such a configuration, planar spreading of the controller 3 can be suppressed, and the installation area of the controller 3 can be suppressed to be small. Therefore, the controller 3 can be easily installed.

In addition, as illustrated in FIG. 4, the control circuit board 54 does not overlap with the power supply circuit board 51 in plan view in the height direction. Therefore, the control circuit board 54 and the power supply circuit board 51 can be disposed so as to be separated from each other as much as possible in the housing 4, and crosstalk therebetween can be effectively suppressed. As a result, noise is less likely to occur, and the controller 3 can control the robot 2 more accurately.

In addition, as illustrated in FIG. 4, the control circuit board 54 does not overlap with the IF board 56 in plan view in the height direction. Moreover, the control circuit board 54 does not overlap with the motor drive board 55 in plan view in the height direction. According to such a configuration, the length of the housing 4 in the height direction can be suppressed, and the controller 3 can be reduced in size. In addition, the control circuit board 54 is disposed closer to the first side panel 43 and the front panel 41 in plan view in the height direction. The motor drive board 55 is disposed on the second side panel 44 side of the control circuit board 54, and the power supply circuit board 51 is disposed on the rear panel 42 side of the control circuit board 54. According to such a configuration, the control circuit board 54, the power supply circuit board 51, and the motor drive board 55 can be arranged in a space-saving and compact manner without being overlapped with each other. Therefore, the controller 3 can be reduced in size.

In addition, as illustrated in FIGS. 2 and 4, the control circuit board 54 is a system on a chip (SOC) including electronic components such as a central processing unit (CPU) 541 and a memory (not illustrated). The memory stores various programs and data required for the controller 3 to control driving of the robot 2, such as an operation command program. The control circuit board 54 operates when a processor reads and executes data, an operation command program, and the like stored in the memory. Specifically, the control circuit board 54 generates a position command indicating a movement destination of the robot 2 based on a target position of the robot 2 set by the operation command program and the actual position of the robot 2 specified from an output signal of each encoder E. In particular, as in the present embodiment, when the conveyor 8 and the camera 9 are connected in addition to the robot 2, the control circuit board 54 generates a position command indicating a movement destination of the robot 2 based on a target position of the robot 2 set by the operation command program, the actual position of the robot 2 specified from an output signal of each encoder E, a position of the workpiece W at a predetermined time obtained from imaging data captured by the camera 9, and a predicted movement trajectory of the workpiece W obtained based on the transport speed of the workpiece W by the conveyor 8.

In addition, as illustrated in FIGS. 2 and 4, the control circuit board 54 has a plurality of second connectors C2. The plurality of second connectors C2 is arranged in a line in the width direction along a side of an upper surface of the control circuit board 54 on the front panel 41 side and faces the outside of the controller 3 through holes formed in the front panel 41. The plurality of second connectors C2 includes, for example, a connector to which the host computer 7 is connected and to which an operation command program is input. The number, arrangement, functions, specifications, and the like of the second connectors C2 are not particularly limited.

In addition, as illustrated in FIG. 4, the control circuit board 54 has an opening 543 formed at a position overlapping with the screw N for fixing the system circuit board 53 to the leg 40 in plan view in the height direction. In the present embodiment, the opening 543 is constituted by a cutout that opens at an edge of the control circuit board 54. According to such a configuration, for example, by inserting a tool such as a driver into the opening 543, attachment and detachment work of the screw N can be easily performed even in a state where the control circuit board 54 is fixed to the system circuit board 53. Therefore, the assemblability and maintainability of the controller 3 are improved.

Here, the number of connectors for cable connection disposed on the control circuit board 54 is preferably smaller than the number of connectors for cable connection disposed on the system circuit board 53. More preferably, the number of connectors for cable connection disposed on the control circuit board 54 is preferably zero. With such a configuration, bending deformation of the control circuit board 54 due to insertion and removal of cables can be suppressed, and a board failure such as a contact failure can be effectively suppressed.

Although the control circuit board 54 has been described above, the configuration of the control circuit board 54 is not particularly limited. For example, the control circuit board 54 may be disposed below the system circuit board 53, that is, between the bottom panel 45 and the system circuit board 53. Alternatively, similarly to the motor drive board 55, the control circuit board 54 may be erected with respect to the system circuit board 53.

### Motor Drive Board 55

As illustrated in FIGS. 2 and 3, two motor drive boards 55 are disposed. Each motor drive board 55 is located on the power supply circuit board 51 and the system circuit board 53 and overlaps with the power supply circuit board 51 and the system circuit board 53 in plan view in the height direction. In addition, each motor drive board 55 is disposed along the second side panel 44. In particular, in the present embodiment, each motor drive board 55 is parallel to the second side panel 44 (orthogonal to the power supply circuit board 51 and the system circuit board 53). That is, each motor drive board 55 is erected with respect to the power supply circuit board 51 and the system circuit board 53. In addition, the respective motor drive boards 55 are disposed closer to the second side panel 44 and arranged side by side in the width direction. In this manner, by disposing the motor drive boards 55 in an erected manner, planar spreading of the controller 3 can be suppressed, and the installation area of the controller 3 can be suppressed to be small. Therefore, the controller 3 can be easily installed.

In addition, each motor drive board 55 is fitted into a connector disposed on an upper surface of the power supply circuit board 51 and a connector disposed on the upper surface of the system circuit board 53 and is electrically connected to the power supply circuit board 51 and the system circuit board 53. Although not illustrated, each motor drive board 55 is fixed to the housing 4 via a support beam near an upper end of the motor drive board 55.

One of the two motor drive boards 55 described above generates multi-phase AC voltages for the motors M1 and M2, and the other generates multi-phase AC voltages for the motors M3 and M4. Since the two motor drive boards 55 have the same configuration, the motor drive board 55 that generates the multi-phase AC voltages for the motors M1 and M2 will be described below as a representative example.

Although not illustrated, the motor drive board 55 is provided with a power module for generating a multi-phase AC voltage for the motor M1 and a second power module for generating a multi-phase AC voltage for the motor M2.

To the first power module, the first voltage V1 is input from the power supply circuit board 51, and the second voltage V2 and a control signal for the motor M1 are input from the system circuit board 53. The first power module is driven by the second voltage V2 (DC voltage of 17 V) and boosts the first voltage V1 (DC voltage of 280 V) to a voltage suitable for driving the motor M1 by a built-in converter. Moreover, the first power module incorporates an inverter circuit composed of a plurality of switching elements, and the inverter circuit is ON/OFF controlled by the control signal for the motor M1 input from the system circuit board 53, whereby the voltage boosted by the converter is converted into a multi-phase AC voltage (three-phase AC voltage) which is a voltage for the motor M1. The multi-phase AC voltage generated by the first power module in this manner is input to the motor M1.

Similarly to the first power module described above, to the second power module, the first voltage V1 is input from the power supply circuit board 51, and the second voltage V2 and a control signal for the motor M2 are input from the system circuit board 53. The second power module is driven by the second voltage V2 and boosts the first voltage V1 to a voltage suitable for driving the motor M2 by a built-in converter. Moreover, the second power module incorporates an inverter circuit composed of a plurality of switching elements, and the inverter circuit is ON/OFF controlled by the control signal for the motor M2 input from the system circuit board 53, whereby the voltage boosted by the converter is converted into a multi-phase AC voltage (three-phase AC voltage) which is a voltage for the motor M2. In this manner, the multi-phase AC voltage generated by the second power module is input to the motor M2.

Although the motor drive board 55 has been described above, the configuration of the motor drive board 55 is not particularly limited. For example, one motor drive board 55 may be configured to generate a multi-phase AC voltage for one motor. In addition, each motor drive board 55 may be disposed parallel to the bottom panel 45.

### Safety Board 57

As illustrated in FIGS. 2 and 6, the safety board 57 is located above the control circuit board 54 and is fixed to the housing 4 with a supporting member 49 interposed therebetween. That is, the safety board 57 is not supported by the control circuit board 54 and is disposed in a state of floating from the control circuit board 54. In addition, the safety board 57 has a substantially rectangular shape in plan view and has substantially the same size as the control circuit board 54. That is, the safety board 57 is smaller in area than the system circuit board 53. In this manner, by disposing the safety board 57 above the system circuit board 53 and the control circuit board 54, that is, by disposing the system circuit board 53 and the control circuit board 54 between the bottom panel 45 and the safety board 57, the safety board 57 is not hidden under the system circuit board 53 and is easily visible.

In addition, as illustrated in FIG. 6, the safety board 57 overlaps with the system circuit board 53 and the control circuit board 54 in plan view in the height direction. According to such a configuration, planar spreading of the controller 3 can be suppressed, and the installation area of the controller 3 can be suppressed to be small. Therefore, the controller 3 can be easily installed.

In addition, as illustrated in FIG. 6, the safety board 57 does not overlap with the power supply circuit board 51 in plan view in the height direction. Therefore, the safety board 57 and the power supply circuit board 51 can be disposed so as to be separated from each other as much as possible in the housing 4, and crosstalk therebetween can be effectively suppressed. As a result, noise is less likely to occur, and the controller 3 can control the robot 2 more accurately.

In addition, as illustrated in FIG. 6, the safety board 57 does not overlap with the motor drive board 55 in plan view in the height direction. According to such a configuration, the length of the housing 4 in the height direction can be suppressed, and the controller 3 can be reduced in size.

In addition, as illustrated in FIGS. 2 and 6, the safety board 57 has a plurality of fourth connectors C4. The plurality of fourth connectors C4 is arranged in a line in the width direction along a side of an upper surface of the safety board 57 on the front panel 41 side and faces the outside of the controller 3 through holes formed in the front panel 41. The plurality of fourth connectors C4 includes, for example, connectors for acquiring an emergency stop input signal and a safety input/output signal. However, the number, arrangement, functions, specifications, and the like of the fourth connectors C4 are not particularly limited.

The safety board 57 monitors an output signal of each encoder E and detects an abnormality of the robot 2. A method of detecting an abnormality is not particularly limited, and for example, when an output signal of at least one encoder E has an abnormal value, it may be determined that the robot 2 has an abnormality. In addition, when an error between a position command generated by the control circuit board 54 and the actual position of the robot 2 obtained from an output signal of each encoder E exceeds an allowable range, it may be determined that the robot 2 has an abnormality. When an abnormality of the robot 2 is detected, the safety board 57 inputs an abnormality signal indicating the abnormality to the system circuit board 53. The system circuit board 53 that has received the abnormality signal promptly stops driving of each of the motors M1 to M4 and urgently stops the robot 2.

Although the safety board 57 has been described above, the configuration of the safety board 57 is not particularly limited. In addition, the safety board 57 may be omitted. Fan 58

As illustrated in FIGS. 2 and 3, the fan 58 is disposed in an erected manner between the power supply circuit board 51 and the sub-power supply circuit board 52 in plan view in the height direction and blows air to the second side panel 44 side (the power supply circuit board 51 side). As a result, a regenerative resistor (not illustrated) and the power supply circuit board 51 can be effectively cooled. In addition, the fan 58 is electrically connected to the system circuit board 53 through a cable, and driving of the fan 58 is controlled based on the power supply from the system circuit board 53.

The controller 3 has been described above. In the controller 3 described above, as illustrated in FIG. 7, the first connectors C1 disposed on the system circuit board 53, the second connectors C2 disposed on the control circuit board 54 and the third connector C3 disposed on the IF board 56, and the fourth connectors C4 disposed on the safety board 57 are disposed to be shifted in the height direction. Specifically, the plurality of first connectors C1 is arranged in a lower stage R1, the plurality of second connectors C2 and one third connector C3 are arranged in a middle stage R2 located above the lower stage R1, and the plurality of fourth connectors C4 is arranged in an upper stage R3 located above the middle stage R2. In this manner, the first, second, third, and fourth connectors C1, C2, C3, and C4 are arranged so as to be vertically separated from each other, and thus it is possible to secure a wide pitch between adjacent connectors without increasing the length of the controller 3 in the width direction. Therefore, it is possible to reduce the controller 3 in size while suppressing deterioration in the operability of the controller 3.

In the present embodiment, the control circuit board 54 and the IF board 56 are disposed at substantially the same height, and the second connectors C2 and the third connector C3 are arranged side by side in the middle stage R2, but the present disclosure is not limited thereto, and the second connectors C2 and the third connector C3 may be arranged to be shifted in the height direction.

The robot system 1 has been described above. As described above, the controller 3 included in the robot system 1 controls driving of the robot 2 on which the motors M1 to M4 are mounted, the controller 3 including the housing 4 including the bottom panel 45, the front panel 41 located on a first side in the depth direction, which is the first direction along the bottom panel 45, and standing with respect to the bottom panel 45, and the rear panel 42 located on a second side in the depth direction and standing with respect to the bottom panel 45, the power supply circuit board 51 disposed in the housing 4 and handling the first voltage V1, and the control circuit board 54 and the system circuit board 53 disposed in the housing 4 and handling the second voltage V2 smaller than the first voltage V1. In addition, the power supply circuit board 51 and the system circuit board 53 are disposed along the bottom panel 45 and are arranged side by side in the depth direction such that the power supply circuit board 51 is located on the second side in the depth direction and the system circuit board 53 is disposed on the first side in the depth direction, the control circuit board 54 is disposed to overlap with the system circuit board 53 in plan view of the bottom panel 45, that is, in plan view in the height direction, the system circuit board 53 has the first connectors C1 connected to the robot 2, and the control circuit board 54 has the second connectors C2 exposed from the front panel 41 to the outside of the housing 4 and connected to the host computer 7 which is an external device that generates a drive command program for the robot 2. According to such a configuration, the second connectors C2 are disposed above the first connectors C1. In this manner, the first and second connectors C1 and C2 are arranged vertically in two rows, and thus it is possible to secure a wide pitch between the first and second connectors C1 and C2 without increasing the length of the controller 3 in the width direction. Therefore, it is possible to reduce the controller 3 in size while suppressing deterioration in the operability of the controller 3. In addition, by arranging the power supply circuit board 51 and the system circuit board 53 side by side in the depth direction, crosstalk therebetween is less likely to occur, and the controller 3 can control the robot 2 accurately.

In addition, as described above, the control circuit board 54 is smaller in area than the system circuit board 53, and the system circuit board 53 is disposed between the bottom panel 45 and the control circuit board 54. According to such a configuration, the control circuit board 54 is not hidden under the system circuit board 53 and is easily visible.

In addition, as described above, the power supply circuit board 51 converts the first voltage V1 into the second voltage V2 and outputs the second voltage V2 to the control circuit board 54, the control circuit board 54 is driven by the second voltage V2, includes the CPU 541, and generates a position command indicating a movement destination of the robot 2 based on an operation command program, and the system circuit board 53 generates a voltage command for each of the motors M1 to M4 necessary for moving the robot 2 to a position indicated by the position command. According to such a configuration, it is possible to control the robot 2 accurately.

In addition, as described above, the controller 3 includes the motor drive board 55 that is disposed in the housing 4 and converts the first voltage V1 input from the power supply circuit board 51 into the voltage for each of the motors M1 to M4 based on the voltage command input from the system circuit board 53, and the control circuit board 54 does not overlap with the motor drive board 55 in plan view in the height direction. According to such a configuration, the length of the housing 4 in the height direction can be suppressed, and the controller 3 can be reduced in size.

In addition, as described above, the motor drive board 55 is erected with respect to the control circuit board 54 and the system circuit board 53. According to such a configuration, planar spreading of the controller 3 can be suppressed, and the installation area of the controller 3 can be suppressed to be small. Therefore, the controller 3 can be easily installed.

In addition, as described above, the housing 4 includes the first side panel 43 and the second side panel 44 that connect the front panel 41 and the rear panel 42 and are arranged side by side in the width direction, which is the second direction orthogonal to the depth direction, in plan view in the height direction. In addition, the control circuit board 54 is disposed closer to the first side panel 43 and the front panel 41, the motor drive board 55 is disposed on the second side panel 44 side of the control circuit board 54, and the power supply circuit board 51 is disposed on the rear panel 42 side of the control circuit board 54. According to such a configuration, the control circuit board 54, the power supply circuit board 51, and the motor drive board 55 do not overlap with each other and can be disposed in a space-saving and compact manner. Therefore, the controller 3 can be reduced in size.

In addition, as described above, the controller 3 includes the safety board 57 that is disposed in the housing 4 and detects an abnormality of the robot 2, and the safety board 57 overlaps with the control circuit board 54 and does not overlap with the power supply circuit board 51 in plan view in the height direction. In this manner, by disposing the safety board 57 so as to overlap with the control circuit board 54, planar spreading of the controller 3 can be suppressed, and the installation area of the controller 3 can be suppressed to be small. Therefore, the controller 3 can be easily installed. In addition, by disposing the safety board 57 so as not to overlap with the power supply circuit board 51, it is possible to dispose the safety board 57 and the power supply circuit board 51 so as to be separated from each other as much as possible in the housing 4, and it is possible to effectively suppress crosstalk therebetween. As a result, noise is less likely to occur, and the controller 3 can control the robot 2 more accurately.

In addition, as described above, the safety board 57 is smaller in area than the system circuit board 53 in plan view in the height direction, and the system circuit board 53 and the control circuit board 54 are disposed between the bottom panel 45 and the safety board 57. According to such a configuration, the safety board 57 is not hidden under the system circuit board 53 and is easily visible.

In addition, as described above, the controller 3 includes the IF board 56 that is disposed in the housing 4, overlaps with the system circuit board 53, and does not overlap with the power supply circuit board 51 in plan view in the height direction. In addition, the IF board 56 has the third connector C3 that is exposed from the front panel 41 to the outside of the housing 4 and to which driving information of the conveyor 8 as a peripheral device that cooperates with the robot 2 is input. According to such a configuration, the controller 3 with high function expandability is obtained.

In addition, as described above, the controller 3 includes the floating connector 59 that electrically connects the system circuit board 53 and the control circuit board 54. According to such a configuration, it is possible to absorb a mounting deviation between the system circuit board 53 and the control circuit board 54 which occurs at the time of mounting, and a load is unlikely to be imposed on the system circuit board 53 and the control circuit board 54.

In addition, as described above, the thickness T1 of the system circuit board 53 is greater than the thickness T2 of the control circuit board 54. According to such a configuration, the strength of the system circuit board 53 is increased, and it is possible to effectively suppress breakage of the system circuit board 53 due to stress imposed at the time of connector connection.

In addition, as described above, the controller 3 includes the screw N as a fixing member that fixes the system circuit board 53 to the bottom panel 45. In addition, the control circuit board 54 has the opening 543 formed at a position overlapping with the screw N in plan view in the height direction. According to such a configuration, for example, by inserting a tool such as a driver into the opening 543, attachment and detachment work of the screw N can be easily performed even in a state where the control circuit board 54 is fixed to the system circuit board 53. Therefore, the assemblability and maintainability of the controller 3 are improved.

In addition, as described above, the controller 3 includes the IF board 56 that is disposed in the housing 4 so as to overlap with the system circuit board 53 and so as not to overlap with the power supply circuit board 51 in plan view of the bottom panel 45 and acquires driving information of the conveyor 8 as a peripheral device that cooperates with the robot 2, and the safety board 57 that is disposed in the housing 4 so as to overlap with the system circuit board 53 and the control circuit board 54 and so as not to overlap with the power supply circuit board 51 in plan view of the bottom panel 45, acquires driving information of the robot 2, and detects an abnormality of the robot 2. In addition, the system circuit board 53 and the control circuit board 54 are disposed between the bottom panel 45 and the safety board 57, the IF board 56 has the third connector C3 that is exposed from the front panel 41 to the outside of the housing 4 and to which the driving information of the conveyor 8 is input, the safety board 57 has the fourth connectors C4 that are exposed from the front panel 41 to the outside of the housing 4 and to which an output signal of each encoder E, which is the driving information of the robot 2, is input, and the first connectors C1, the second connectors C2 and the third connector C3, and the fourth connectors C4 are arranged to be shifted in a normal direction of the bottom panel 45, that is, the height direction. In this manner, the first, second, third, and fourth connectors C1, C2, C3, and C4 are arranged so as to be vertically shifted from each other, and thus it is possible to secure a wide pitch between the first, second, third, and fourth connectors C1, C2, C3, and C4 without increasing the length of the controller 3 in the width direction. Therefore, it is possible to reduce the controller 3 in size while suppressing deterioration in the operability of the controller 3.

Although the controller of the present disclosure has been described based on the embodiment illustrated in the drawings, the present disclosure is not limited thereto, and the configuration of each portion can be replaced with an arbitrary configuration having the same function. In addition, any other configurations may be added to the present disclosure.

## Claims

1. A controller that controls driving of a robot on which a motor is mounted, the controller comprising:
a housing including a bottom panel, a front panel located on a first side in a first direction along the bottom panel and standing with respect to the bottom panel, and a rear panel located on a second side in the first direction and standing with respect to the bottom panel;
a power supply circuit board that is disposed in the housing and to which a first voltage is input; and
a control circuit board and a system circuit board that are disposed in the housing and to which a second voltage smaller than the first voltage is input, wherein
the power supply circuit board and the system circuit board are disposed along the bottom panel and are arranged side by side in the first direction such that the power supply circuit board is located on the second side in the first direction and the system circuit board is located on the first side in the first direction,
the control circuit board is disposed to overlap with the system circuit board in plan view of the bottom panel,
the system circuit board has a first connector connected to the robot, and
the control circuit board has a second connector exposed from the front panel to an outside of the housing and connected to an external device that generates a drive command program for the robot.

2. The controller according to claim 1, wherein
the control circuit board is smaller in area than the system circuit board, and
the system circuit board is disposed between the bottom panel and the control circuit board.

3. The controller according to claim 1, wherein
the power supply circuit board converts the first voltage into the second voltage and outputs the second voltage to the control circuit board,
the control circuit board
is driven by the second voltage,
includes a central processing unit (CPU), and
generates a position command indicating a movement destination of the robot based on an operation command program, and
the system circuit board generates a voltage command for the motor necessary for moving the robot to a position indicated by the position command.

4. The controller according to claim 3, further comprising
a motor drive board that is disposed in the housing and converts the first voltage input from the power supply circuit board into a voltage for the motor based on the voltage command input from the system circuit board, wherein
the control circuit board does not overlap with the motor drive board in plan view of the bottom panel.

5. The controller according to claim 4, wherein
the motor drive board is erected with respect to the control circuit board and the system circuit board.

6. The controller according to claim 5, wherein
the housing includes a first side panel and a second side panel that connect the front panel and the rear panel and are arranged side by side in a second direction orthogonal to the first direction in plan view of the bottom panel,
the control circuit board is disposed closer to the first side panel and the front panel, the motor drive board is disposed on the second side panel side of the control circuit board, and
the power supply circuit board is disposed on the rear panel side of the control circuit board.

7. The controller according to claim 1, further comprising
a safety board that is disposed in the housing and detects an abnormality of the robot, wherein
the safety board overlaps with the control circuit board and does not overlap with the power supply circuit board in plan view of the bottom panel.

8. The controller according to claim 7, wherein
the safety board is smaller in area than the system circuit board in plan view of the bottom panel, and
the system circuit board and the control circuit board are disposed between the bottom panel and the safety board.

9. The controller according to claim 1, further comprising
an interface (IF) board that is disposed in the housing, overlaps with the system circuit board, and does not overlap with the power supply circuit board in plan view of the bottom panel, wherein
the IF board has a third connector that is exposed from the front panel to the outside of the housing and to which driving information of a peripheral device that cooperates with the robot is input.

10. The controller according to claim 1, further comprising
a floating connector that electrically connects the system circuit board and the control circuit board.

11. The controller according to claim 1, wherein
a thickness of the system circuit board is greater than a thickness of the control circuit board.

12. The controller according to claim 1, further comprising
a fixing member that fixes the system circuit board to the bottom panel, wherein the control circuit board has an opening formed at a position overlapping with the fixing member in plan view of the bottom panel.

13. The controller according to claim 1, further comprising:
an IF board that is disposed in the housing to overlap with the system circuit board and not to overlap with the power supply circuit board in plan view of the bottom panel and acquires driving information of a peripheral device that cooperates with the robot; and
a safety board that is disposed in the housing to overlap with the system circuit board and the control circuit board and not to overlap with the power supply circuit board in plan view of the bottom panel, acquires driving information of the robot, and detects an abnormality of the robot, wherein
the system circuit board and the control circuit board are disposed between the bottom panel and the safety board,
the IF board has a third connector that is exposed from the front panel to the outside of the housing and to which the driving information of the peripheral device is input,
the safety board has a fourth connector that is exposed from the front panel to the outside of the housing and to which the driving information of the robot is input, and
the first connector, the second connector and the third connector, and the fourth connector are arranged to be shifted in a normal direction of the bottom panel.
